# EUROPEAN PATENT APPLICATION

(11) **EP 2 544 255 A2**
(43) Date of publication of application: **09.01.2013**
(21) Application number: 12175078.0
(22) Date of filing: 05.07.2012
(51) Int. Cl.: H01L 35/32

(54) **Thermoelectric conversion device and method for manufacturing the same**

(30) Priority: 08.07.2011 JP 2011151640
(71) Applicant: Kabushiki Kaisha Toyota Jidoshokki, Kariya-shi, Aichi 448-8671 (JP)
(72) Inventor: Akiyama, Hirokuni, Kariya-shi, Aichi 448-8671 (JP); Mune, Shimpei, Kariya-shi, Aichi 448-8671 (JP); Morisaku, Naoto, Kariya-shi, Aichi 448-8671 (JP); Tanaka, Toshimitsu, Kariya-shi, Aichi 448-8671 (JP)
(74) Representative: TBK

(57) **Abstract**

The present invention relates to a thermoelectric conversion device that applies appropriate compressive stress to thermoelectric elements with a simple structure, thereby protecting the thermoelectric element, and to a method for manufacturing the device. A thermoelectric conversion device 11 includes a first board 15, a second board 26, which is arranged to face the first board 15, and thermoelectric elements 22. One end of each thermoelectric element 22 is joined to a first electrode layer on the first board, and the other end is joined to a second electrode layer 24 on the second board 26. The thermoelectric conversion device 11 includes reinforcing members 30. One end of each reinforcing members 30 joined to the first insulating plate 15a, and the other end is joined a second insulating plate 26a. In the thermoelectric conversion device 11, the coefficient of linear expansion of the reinforcing members 30 is greater than the coefficient of linear expansion of the thermoelectric elements 22.

## Description

### BACKGROUND OF THE INVENTION

The present invention relates to a thermoelectric conversion device having a reinforcing member, which has one end joined to a first board and another end joined to a second board. The present invention also relates to a method for manufacturing the thermoelectric conversion device.

A typical thermoelectric conversion device includes a pair of boards facing each other, thermoelectric elements joined to the board, for example, by soldering. The thermoelectric elements are capable of performing conversion between thermal energy and electric energy. In such a thermoelectric conversion device, a heat exchanger is mounted on the outer surface of each board. The heat exchangers are held at predetermined positions while being kept in tight contact with each other via grease by fixing members.

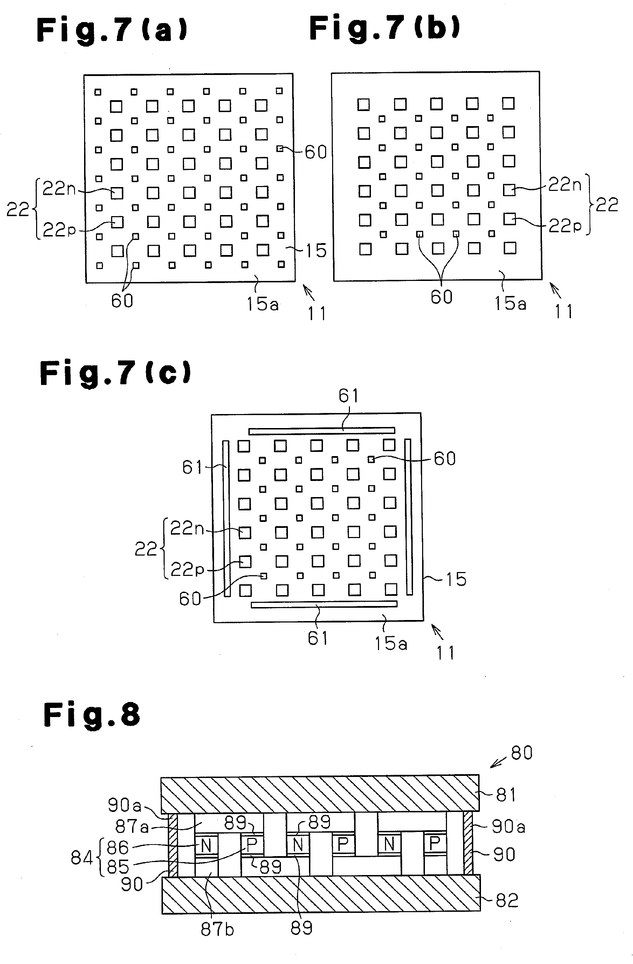

Fig. 8 illustrates a thermoelectric conversion device 80 disclosed in Japanese Laid-Open Patent Publication No. 9-92890. The thermoelectric conversion device 80 has a substantially plate-like high-temperature side heat exchanger 81 and a substantially plate-like low-temperature side heat exchanger 82, which face each other. A number of thermoelectric elements 84, which include by p-type semiconductors 85 and n-type semiconductors 86, are located between the heat exchangers 81, 82. A first electrode 87a is attached to the high-temperature side heat exchanger 81, and a second electrode 87b is attached to the low-temperature side heat exchanger 82. The thermoelectric elements 84 are joined to the first electrode 87a and the second electrode 87b via joining layers 89, which are made, for example, of solder.

The positions of the heat exchangers 81, 82 in the thermoelectric conversion device 80 are determined by fixing portions 90 such that the heat exchangers 81, 82 tightly hold the thermoelectric elements 84 and first and second electrodes 87a, 87b. Each fixing portion 90 includes a bolt-like fixing main body 90a and a nut-like fastener (not shown), which is threaded to the fixing main body 90a. The fixing portions 90 maintain a constant holding force by which the heat exchangers 81, 82 hold the thermoelectric elements 84.

The coefficient of thermal expansion of the fixing portions 90 is greater than the coefficient of thermal expansion of thermoelectric elements 84, the first electrode 87a, and the second electrode 87b. When heated and thermally expanded, the high-temperature side heat exchanger 81 acts to compress the thermoelectric elements 84. However, since the fixing main bodies 90a of the fixing portions 90 are thermally expanded by a greater degree, an increase in the holding force in the fastening direction generated in the thermoelectric elements 84, in other words, compressive stress, is limited.

However, the fixing portions 90 hold from outside the high-temperature side heat exchanger 81 and low-temperature side heat exchanger 82, which are located outside of the first electrode 87a and the second electrode 87b, which serve as boards. Thus, the compressive stress acting on the thermoelectric elements 84 can vary depending on the conditions of the thermal expansion of the heat exchangers 81, 82. If the compressive stress is too strong, undesirable force acting on the thermoelectric elements 84 will be excessive. If the fastening force is too weak, the electrodes 87a, 87b are deformed or displaced, and the thermoelectric elements 84 may be broken.

### SUMMARY OF THE INVENTION

Accordingly, it is an objective of the present invention to provide a thermoelectric conversion device that applies appropriate compressive stress to thermoelectric elements with a simple structure, thereby protecting the thermoelectric elements, and a method for manufacturing the device.

One aspect of the present invention is a thermoelectric conversion device comprising: a first board; a second board, which is arranged to face the first board; a thermoelectric element, wherein one end of the thermoelectric element is joined to an electrode layer of the first board, and the other end of the thermoelectric element is joined to an electrode layer of the second board; and a reinforcing member, wherein one end of the reinforcing member is joined to the first board and the other end of the reinforcing member is joined to the second board, wherein the coefficient of linear expansion of the reinforcing member is greater than the coefficient of linear expansion of the thermoelectric element, and wherein the reinforcing member causes compressive stress to act on the thermoelectric elements.

Since the first board and the second board are coupled to each other by the reinforcing members, the boards are not influenced by thermal expansion of heat exchanging members and the like, so that compressive stress acting on the thermoelectric elements is easily set to an appropriate value. Since the thermoelectric elements receive appropriate compressive stress and are therefore protected.

Other aspects and advantages of the invention will become apparent from the following description, taken in conjunction with the accompanying drawings, illustrating by way of example the principles of the invention.

### BRIEF DESCRIPTION OF THE DRAWINGS

The invention, together with objects and advantages thereof, may best be understood by reference to the following description of the presently preferred embodiments together with the accompanying drawings in which:
Fig. 1 is an exploded perspective view illustrating a thermoelectric conversion device according to a first embodiment of the present invention;
Fig. 2 is a plan view showing the first board of the thermoelectric conversion device;
Fig. 3 is a cross-sectional side view showing the thermoelectric conversion device;
Fig. 4 is a cross-sectional front view showing the thermoelectric conversion device;
Fig. 5(a) is a partial enlarged view of the thermoelectric conversion device, showing a state when thermoelectric elements and reinforcing members are joined to the boards;
Fig. 5(b) is a partial enlarged view showing the thermoelectric conversion device at a normal temperature;
Fig. 5(c) is a partial enlarged view showing the thermoelectric conversion device during operation;
Fig. 6 is a partial enlarged view illustrating a thermoelectric conversion device according to a second embodiment of the present invention;
Fig. 7(a) is a plan view showing a reinforcing member according to a modification;
Fig. 7(b) is a plan view showing a reinforcing member according to a modification;
Fig. 7(c) is a plan view showing a reinforcing member according to a modification; and
Fig. 8 is a cross-sectional view showing a prior art thermoelectric conversion device.

### DETAILED DESCRIPTION OF THE PREFERRED EMBODIMENTS

### (First Embodiment)

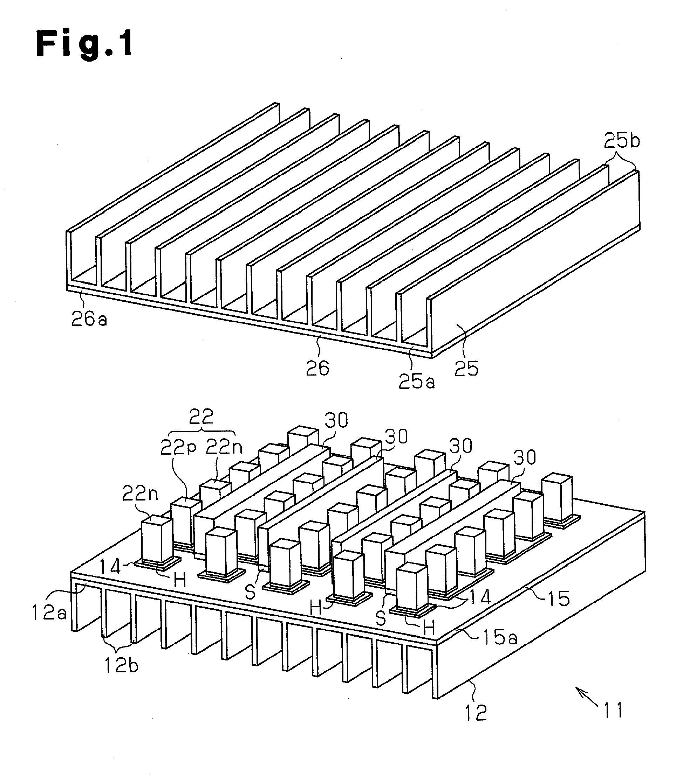

A first embodiment of the present invention will now be described with reference to Figs. 1 to 5.

As shown in Figs. 1 to 4, a thermoelectric conversion device 11 includes a first heat exchanging member 12, which is made of an insulating material such as ceramics (nonconductive material). The first heat exchanging member 12 of the present embodiment is made of aluminum nitride. The first heat exchanging member 12 is formed by a rectangular plate-like base 12a and a plurality of fins 12b, which are arranged in parallel at predetermined intervals on one side of the base 12a.

A first board 15 is brazed to a side of the base 12a of the first heat exchanging member 12 that is opposite to the side on which the fins 12b are provided. The first board 15 is formed by a first insulating plate 15a made of an insulating material such as ceramics and first electrode layers 14 formed on the first insulating plate 15a. The first electrode layers 14 are made of aluminum. The first electrode layers 14 are formed by etching an aluminum layer formed on the first insulating plate 15a. Specifically, the base 12a is brazed to one side of the first insulating plate 15a, and the first electrode layers 14 are formed on the surface that is opposite to the surface to which the base 12a is joined. One end of either an n-type thermoelectric element 22n or a p-type thermoelectric element 22p is joined to each of the first electrode layers 14 via a joining layer H made of solder, such that the n-type thermoelectric elements 22n and the p-type thermoelectric elements 22p are arranged alternately. The n-type thermoelectric elements 22n and the p-type thermoelectric elements 22p are made of Bi₂Te₃, and the coefficient of linear expansion is 16 × 10⁻⁶/°C.

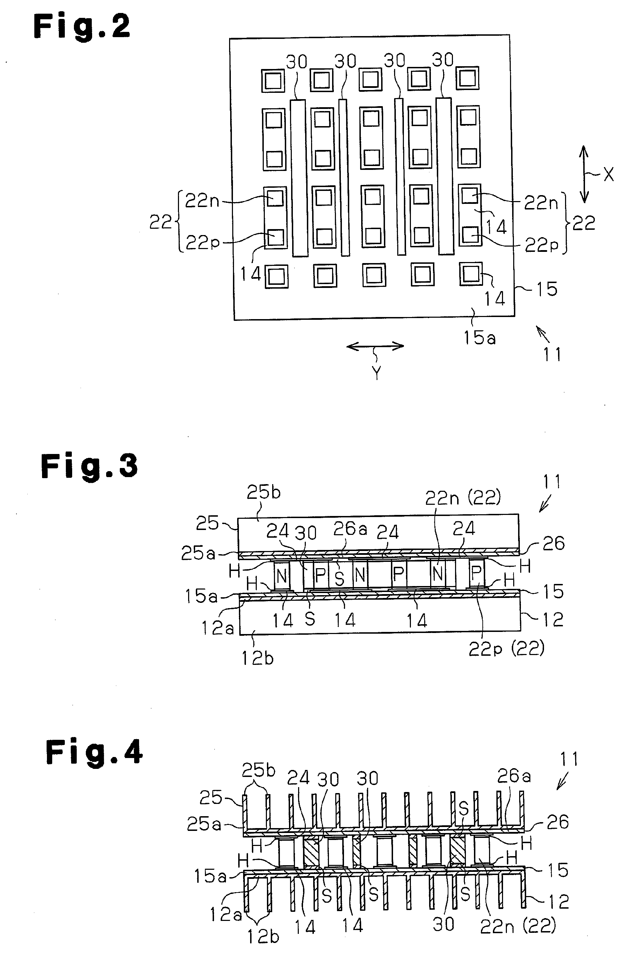

As shown in Figs. 2 to 4, the other ends of the thermoelectric elements 22n, 22p are joined to second electrode layers 24 of a second board 26 via joining layers H made of solder. The second board 26 is formed by a second insulating plate 26a made of an insulating material such as ceramics and second electrode layers 24 formed on the second insulating plate 26a. The second electrode layers 24 are made of aluminum. The second electrode layers 24 are formed by etching an aluminum layer formed on the second insulating plate 26a. The n-type thermoelectric elements 22n and the p-type thermoelectric elements 22p are electrically connected together in series by the first electrode layers 14 and the second electrode layers 24.

The second board 26 is arranged to face the first board 15. A second heat exchanging member 25 is joined to a surface of the second board 26 that is a side opposite to the side on which the second electrode layers 24 are formed. Like the first heat exchanging member 12, the second heat exchanging member 25 is formed by a base 25a and a plurality of fins 25b, which are arranged in parallel on the base 25a. The thermoelectric elements 22, which include the n-type thermoelectric elements 22n and the p-type thermoelectric elements 22p, are tightly held between the first board 15 and the second board 26 via the first electrode layers 14 and the second electrode layers 24. As shown in Fig. 2, on the first board 15 and the second board 26, the direction in which the n-type thermoelectric elements 22n and the p-type thermoelectric elements 22p are connected in series by the first electrode layers 14 and the second electrode layers 24 is defined as a first direction X, and a direction perpendicular to the first direction X is defined as a second direction Y.

As illustrated in Figs. 1, 3 and 4, a plurality of rectangular plate-like reinforcing members 30 are located between the first board 15 and the second board 26, and the first board 15 and the second board 26 are coupled to each other by the reinforcing members 30. Specifically, one end of each reinforcing member 30 is joined to the first insulating plate 15a via a solder joining layer S, and the other end of each reinforcing member 30 is joined to the second insulating plate 26a via a solder joining layer S. The reinforcing members 30 are electrically insulated from the first and second electrode layers 14, 24.

As shown in Fig. 2, the reinforcing members 30 are joined to the first and second boards 15, 26 such that the longitudinal direction thereof matches with the first direction X of the first and second boards 15, 26, and the direction of the shorter sides matches with the second direction Y of the first and second boards 15, 26. The reinforcing members 30 are arranged in the second direction Y, such that each reinforcing member 30 is arranged between adjacent rows of the thermoelectric elements 22 extending in the first direction X. The first and second boards 15, 26 are more easily warped and distorted by greater amounts at positions closer to the edges in the second direction Y. To limit such distortion, the reinforcing members 30 that are located closer to the edges in the second direction Y have a greater thickness (dimension in the second direction) than that of the other reinforcing members 30, which are located inside.

The reinforcing members 30 are made of a material the coefficient of linear expansion of which is greater than those of the n-type thermoelectric elements 22n and the p-type thermoelectric elements 22p. Materials for the reinforcing members 30 include zinc (33 × 10⁻⁶/°C), aluminum (23 × 10⁻⁶/°C), duralumin (23 × 10⁻⁶/°C), brass (20 × 10⁻⁶/°C), and SUS304 (17 × 10⁻⁶/°C).

A method for manufacturing the thermoelectric conversion device 11 will now be described.

First, a joining step is executed, in which the first heat exchanging member 12 is brazed to the first board 15, and the second heat exchanging member 25 is brazed to the second board 26.

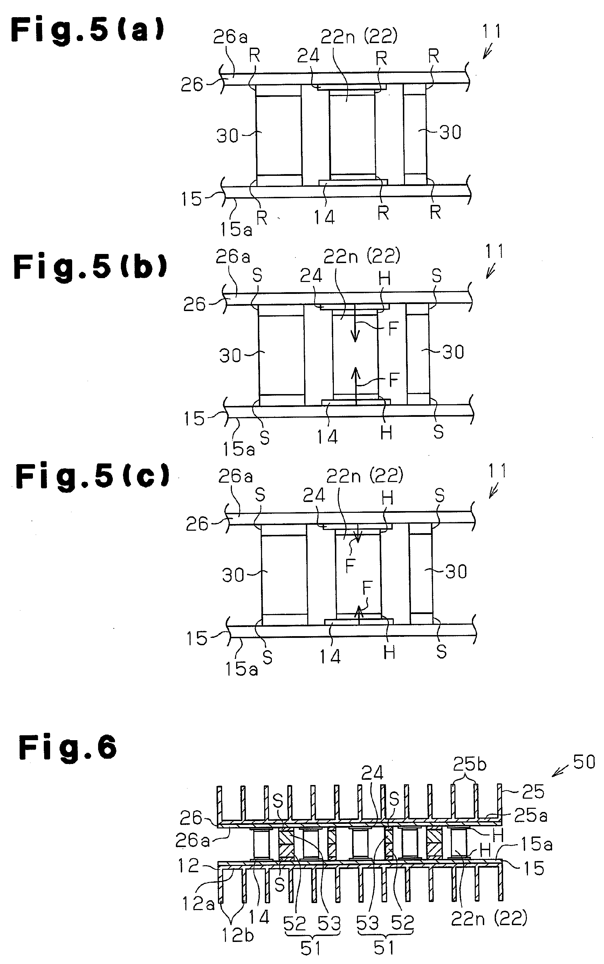

Subsequently, a laminating step is performed. That is, as shown in Fig. 5(a), each of thermoelectric elements 22n, 22p is tightly held between a second electrode layer 24 on the second board 26 and a first electrode layer 14 on the first board 15, and the reinforcing members 30 are tightly held between the first board 15 and the second board 26. Solder R, which is the material for the joining layers H and S, is located between the first electrode layers 14 and one end (lower end) of each of the thermoelectric elements 22n, 22p, between the second electrode layers 24 and other end (upper end) of each of the thermoelectric elements 22n, 22p, between the first board 15 and one end (lower end) of each of the reinforcing members 30, and between the second board 26 and the other end of each of the reinforcing members 30.

Next, a heating step for heating the solder R to the melting point is executed. When the solder R is melted, the thermoelectric elements 22 and the reinforcing members 30 are heated and thermally expanded upward. When the thermoelectric elements 22 and the reinforcing members 30 are thermally expanded, the upper ends of the thermoelectric elements 22 and the upper ends of the reinforcing members 30 are at the same height. That is, thermoelectric elements 22 and the reinforcing members 30 are adjusted in advance such that these have the same height at the melting point of the solder R. The first and second electrode layers 14, 24 are not formed between the reinforcing members 30 and the first and second boards 15, 26.

When the solder R is cooled, the joining layers H join the thermoelectric elements 22 to the first and second electrode layers 14, 24, and the joining layers S join the reinforcing members 30 to the first and second insulating plates 15a, 26a. Accordingly, production of thermoelectric conversion device 11 is completed. The thermoelectric elements 22 and the reinforcing members 30 are contracted from the thermally expanded state through a cooling step.

At this time, since the reinforcing members 30 have a greater coefficient of linear expansion than the thermoelectric elements 22, the reinforcing members 30 are contracted by a greater degree than the thermoelectric elements 22. Therefore, when the thermoelectric conversion device 11 operates at a normal temperature, the height of the reinforcing members 30 is lower than the height of the thermoelectric elements 22. As shown in Fig. 5(b), the reinforcing members 30 in a contracted state pull the first board 15 and the second board 26 toward each other to reduce the distance between the first board 15 and the second board 26. In this state, stress in a compressing direction (arrows F) is generated in each of the thermoelectric elements 22n, 22p.

In the thermoelectric conversion device 11, which is manufactured in the above described manner, the Peltier effect is caused when the thermoelectric elements 22n, 22p are energized. This allows either the first electrode layers 14 or the second electrode layers 24 to function as heating (high-temperature) side electrode layers and the other electrode layers to function as endothermic (low-temperature) side electrode layers. Accordingly, the first heat exchanging members 12 or the second heat exchanging members 25 heat the corresponding heat exchange medium, and the others cool the corresponding heat exchange medium.

Operation of the thermoelectric conversion device 11 will now be described.

In the thermoelectric conversion device 11, when the thermoelectric elements 22 are activated and the temperature rises, the reinforcing members 30 in the vicinity of the thermoelectric elements 22 receive heat from thermoelectric elements 22 and are heated. In this state, thermoelectric elements 22 and the reinforcing members 30 are both thermally expanded. The thermal expansion of the reinforcing members 30 lessens the pull between the first board 15 and the second board 26 caused by contraction of the reinforcing members 30 during the cooling step. As a result, as indicated by arrows F in Fig. 5(c), the stress in the compressing direction that acts on the thermoelectric elements 22 is reduced.

The above embodiment has the following advantage.
(1) In the thermoelectric conversion device 11, the first board 15 and the second board 26 are coupled to each other by the reinforcing members 30. Therefore, when there is a temperature change in the first and second boards 15, 26, the reinforcing members 30 suppress distortion of the boards 15, 26. Accordingly, pulling stress due to distortion of the boards 15, 26 is not generated in the thermoelectric elements 22.
(2) The coefficient of linear expansion of the reinforcing members 30 is greater than the coefficient of linear expansion of the thermoelectric elements 22 (the n-type the thermoelectric elements 22n and the p-type the thermoelectric elements 22p). Therefore, at a normal temperature, the reinforcing members 30 are contracted by a greater degree than the thermoelectric elements 22, so that the distance between the first board 15 and the second board 26 is decreased. This generates stress in the compressing direction in the thermoelectric elements 22. When the thermoelectric elements 22 are activated and the thermoelectric elements 22 and the reinforcing members 30 are thermally expanded, the reinforcing members 30 are expanded by a greater degree than the thermoelectric elements 22. This reduces the stress in the compressing direction in the thermoelectric elements 22. Therefore, unlike the conventional art, stress generated in the thermoelectric elements 22 is not increased by the influence of thermal expansion of the heat exchangers during operation of the thermoelectric conversion device 11. The thermoelectric elements 22 are thus protected.
(3) Since the coefficient of linear expansion of the reinforcing members 30 is greater than the coefficient of linear expansion of the thermoelectric elements 22, the reinforcing members 30 is contracted by a greater degree than the thermoelectric elements 22 at a normal temperature, so that the height of the reinforcing members 30 is lower than the height of the thermoelectric elements 22. This reduces the distance between the first board 15 and the second board 26 and generates stress in the compressing direction in the thermoelectric elements 22. Since the thermoelectric elements 22 withstands stress in the compressing direction better than stress in the pulling direction, the undesirable force acting on the thermoelectric elements 22 is reduced.
(4) The coefficient of linear expansion of the reinforcing members 30 is greater than the coefficient of linear expansion of the thermoelectric elements 22. Also, the height of the expanded reinforcing members 30 and the height of the thermoelectric elements 22 are adjusted such that these heights become equal to each other when the solder R is heated to the melting point to join the thermoelectric elements 22 and the reinforcing members 30 to the first and second boards 15, 26. Therefore, the reinforcing members 30 can be joined using the solder R, like the thermoelectric elements 22. The compressive stress at a normal temperature and the compressive stress during operation of the thermoelectric conversion device 11 can be adjusted by the coefficient of linear expansion of the reinforcing members 30. Thus, unlike the conventional art, the fastening stress of bolts (fastening portions) do not need to be controlled.
(5) Of the reinforcing members 30, which are arranged in the second direction Y of the first board 15 and the second board 26, the reinforcing members 30 close to both edges are thicker than the reinforcing members 30 located inside. Thus, the reinforcing members 30 prevent the first and second boards 15, 26 from being largely warped at the edges in the second direction Y.
(6) In the thermoelectric conversion device 11 of the present embodiment, the reinforcing members 30 can be arranged between adjacent pairs of the thermoelectric elements 22 as necessary. Therefore, the reinforcing members 30 can be placed at positions where pulling stress is likely to be generated in the thermoelectric elements 22.

### (Second Embodiment)

A second embodiment of the present invention will now be described with reference to Fig. 6. In the following description, like or the same reference numerals are given to those components that are like or the same as the components described above and detailed explanations are omitted.

As shown in Fig. 6, a thermoelectric conversion device 50 includes reinforcing members 51, each of which have two layers stacked in the direction of height. More specifically, each reinforcing member 51 is formed by integrating a first reinforcing member 52, which is closer to the first board 15, and a second reinforcing member 53, which is closer to the second board 26. The first reinforcing members 52 have a lower thermal conductivity than the second reinforcing members 53. In the present embodiment, the first reinforcing members 52 are formed of a low thermal conductivity material. Specifically, zirconia is used as the material for the first reinforcing members 52, and aluminum is used as the material for the second reinforcing members 53.

In addition to the advantages (1) through (6) of the first embodiment, the second embodiment provides the following advantage.
(7) In the thermoelectric conversion device 50, a part of each reinforcing member 51 is formed by a first reinforcing member 52, which is made of a low thermal conductivity material. Therefore, when either of the first electrode layers 14 or the second electrode layers 24 are heated, the heat is not easily transferred to the other electrode layers on the cooling side via the reinforcing members 51.

The above described embodiments may be modified as follows.

In the second embodiment, the reinforcing members 51 are each formed by two different materials. However, the reinforcing members 51 each may be formed by three or more different materials that are layered in the direction of height. In this case, two or more layers of low thermal conductivity materials may be provided. Alternatively, only one layer of a low thermal conductivity material may be provided.

In each of the embodiments, the reinforcing members 30 are formed as rectangular plates, and arranged such that the longitudinal direction thereof matches with the first direction X of the first and second boards 15, 26. However, the arrangement and shapes of reinforcing members may be changed as necessary.

For example, as shown in Fig. 7(a), rod-like reinforcing members 60 may be employed such that the reinforcing members 60 are arranged at equal intervals outside and between the rows of the thermoelectric elements 22n, 22p in the first direction X and the second direction Y.

Alternatively, as shown in Fig. 7(b), rod-like reinforcing members 60 may be arranged at equal interval only between the rows of the thermoelectric elements 22n, 22p in the first direction X and the second direction Y.

Further, as shown in Fig. 7(c), rectangular plate-like reinforcing members 61 may be located along the four sides of the first board 15 and the second board 26, and rod-like reinforcing members 60 may be arranged at equal intervals between rows of the thermoelectric elements 22n, 22p in the first direction X and the second direction Y. In Figs. 7(a) to 7(c), the first electrode layers 14 are not illustrated.

In the illustrated embodiments, the joining layers H, S are formed by solder, but may be formed by brazing filler metal. Also, when the joining layer S is formed by adhesive, the first and second boards 15, 26 are joined to each other with the reinforcing members 30, 51 heated.

Depending on the types of the joining layers H, S or depending on the materials of the first and second boards 15, 26, the reinforcing members 30, 51 may be directly joined to the first and second insulating plates 15a, 26a of the first and second boards 15, 26. In this case, the total height of the thermoelectric elements 22 and the first and second electrode layers 14, 24 and the height of the reinforcing members 30 need to be adjusted in advance such that these heights become equal to each other at the melting point of the solder R.

Therefore, the present examples and embodiments are to be considered as illustrative and not restrictive and the invention is not to be limited to the details given herein, but may be modified within the scope and equivalence of the appended claims.

The present invention relates to a thermoelectric conversion device that applies appropriate compressive stress to thermoelectric elements with a simple structure, thereby protecting the thermoelectric element, and to a method for manufacturing the device. A thermoelectric conversion device 11 includes a first board 15, a second board 26, which is arranged to face the first board 15, and thermoelectric elements 22. One end of each thermoelectric element 22 is joined to a first electrode layer on the first board, and the other end is joined to a second electrode layer 24 on the second board 26. The thermoelectric conversion device 11 includes reinforcing members 30. One end of each reinforcing members 30 joined to the first insulating plate 15a, and the other end is joined a second insulating plate 26a. In the thermoelectric conversion device 11, the coefficient of linear expansion of the reinforcing members 30 is greater than the coefficient of linear expansion of the thermoelectric elements 22.

## Claims

1. A thermoelectric conversion device (11) comprising:
a first board (15);
a second board (26), which is arranged to face the first board (15);
a thermoelectric element (22n, 22p), wherein one end of the thermoelectric element (22n, 22p) is joined to an electrode layer (14) of the first board (15), and the other end of the thermoelectric element (22n, 22p) is joined to an electrode layer (24) of the second board (26); and
a reinforcing member (30, 51, 60, 61), wherein one end of the reinforcing member (30, 51, 60, 61) is joined to the first board (15) and the other end of the reinforcing member (30, 51, 60, 61) is joined to the second board (26),
thermoelectric conversion device (11) being **characterized in that**:
the coefficient of linear expansion of the reinforcing member (30, 51, 60, 61) is greater than the coefficient of linear expansion of the thermoelectric element (22n, 22p), and wherein the reinforcing member (30, 51, 60, 61) causes compressive stress to act on the thermoelectric elements (22n, 22p).

2. The thermoelectric conversion device (11) according to claim 1, **characterized in that** the reinforcing member (30, 51, 60, 61) is joined, together with the thermoelectric element (22n, 22p), to the first board (15) and second board (26) in a state in which the reinforcing member (30, 51, 60, 61) is heated such that its height becomes equal to the height of the thermoelectric element (22n, 22p).

3. The thermoelectric conversion device (11) according to claim 1, **characterized in that**, at a normal temperature, the height of the reinforcing member (30, 51, 60, 61) is less than the height of the thermoelectric element (22n, 22p).

4. The thermoelectric conversion device (11) according to claim 3, **characterized in that**, when the thermoelectric element (22n, 22p) is activated, the height of the reinforcing member (30, 51, 60, 61) is less than the height of the thermoelectric element (22n, 22p).

5. The thermoelectric conversion device (11) according to any one of claims 1 to 4, **characterized in that** the reinforcing member (51) is formed by a plurality of members (52, 53) that are laminated in the direction of height, and at least one of the members (52, 53) is made of a low thermal conductivity material.

6. A method for manufacturing a thermoelectric conversion device (11), therein the device includes:
a first board (15);
a second board (26), which is arranged to face the first board (15);
a thermoelectric element (22n, 22p), wherein one end of the thermoelectric element (22n, 22p) is joined to the first board (15) and the other end of the thermoelectric element (22n, 22p) is joined to the second board (26); and
a reinforcing member (30, 51, 60, 61), wherein one end of the reinforcing member (30, 51, 60, 61) is joined to the first board (15) and the other end of the reinforcing member (30, 51, 60, 61) is joined to the second board (26),
the method being **characterized by** comprising:
selecting, as the reinforcing member (30, 51, 60, 61), a member of which the coefficient of linear expansion is greater than the coefficient of linear expansion of the thermoelectric element (22n, 22p); and
joining the reinforcing member (30, 51, 60, 61) and the thermoelectric element (22n, 22p) to the first board (15) and the second board (26) in a state in which the reinforcing member (30, 51, 60, 61) is heated.

7. The method for manufacturing a thermoelectric conversion device (11) according to claim 6, **characterized in that** the thermoelectric element (22n, 22p) and the reinforcing member (30, 51, 60, 61) are joined, using solder, to the first board (15) and the second board (26).

8. The method for manufacturing a thermoelectric conversion device (11) according to claim 6 or 7, **characterized in that**, in the joining of the reinforcing member (30, 51, 60, 61) and the thermoelectric element (22n, 22p), the reinforcing member (30, 51, 60, 61) and the thermoelectric element (22n, 22p) are joined to the first board (15) and second board (26) in a state in which the reinforcing member (30, 51, 60, 61) is heated such that its height becomes equal to the height of the thermoelectric element (22n, 22p).
